# EUROPEAN PATENT APPLICATION

(11) **EP 2 830 401 A1**
(43) Date of publication of application: **28.01.2015**
(21) Application number: 13846630.5
(22) Date of filing: 16.04.2013
(51) Int. Cl.: H05K 5/00, F24F 7/08

(54) **HEAT EXCHANGER PLATE, HEAT EXCHANGER, AND ENCLOSURE OF COMMUNICATION BASE STATION**

(30) Priority: 15.10.2012 CN 201210390220
(71) Applicant: Huawei Technologies Co., Ltd, Shenzhen, Guangdong 518129 (CN)
(72) Inventor: WANG, Miao, Shenzhen Guangdong 518129 (CN); WANG, Tao, Shenzhen Guangdong 518129 (CN)
(74) Representative: Epping - Hermann - Fischer
(86) International application number: PCT/CN2013/074266
(87) International publication number: WO 2014/059773

(57) **Abstract**

The present invention discloses a heat exchange plate, heat exchanger, and communication base station cabinet, relates to the field of heat exchange apparatus technologies, and is intended to better improve the heat exchange efficiency of a heat exchanger. The heat exchange plate includes a heat exchange plate body that has an air duct, an air inlet is disposed on a first side surface of the heat exchange plate body and an air outlet is disposed on an adjacent second side surface of the heat exchange plate body, the air duct is formed between the air inlet and the air outlet, and a diversion structure for guiding air to flow is disposed in the air duct. The present invention is mainly applied to a heat dissipation apparatus of a cabinet.

## Description

This application claims priority to Chinese Patent Application No. 201210390220.0, filed with the Chinese Patent Office on October 15, 2012 and entitled "HEAT EXCHANGE PLATE, HEAT EXCHANGER, AND COMMUNICATION BASE STATION CABINET", which is incorporated herein by reference in its entirety.

### TECHNICAL FIELD

The present invention relates to the field of heat exchange apparatus technologies, and in particular, to a heat exchange plate, heat exchanger, and communication base station cabinet.

### BACKGROUND

In a communication base station, a large power cabinet usually implements heat dissipation of the large power cabinet in a manner of a heat exchanger or a communication cabinet air conditioner, which ensures heat dissipation and can maintain isolation of an internal component of a communication device from outside, so as to achieve a requirement for reliability of the internal component of the communication device and an IP55 protection level of the communication device.

According to a principle and a manner of heat exchange between cold and hot fluids, heat exchangers are generally classified into a recuperative heat exchanger, a mixed heat exchanger, and a regenerative heat exchanger. In a large power cabinet of a communication base station, the recuperative heat exchanger is commonly used.

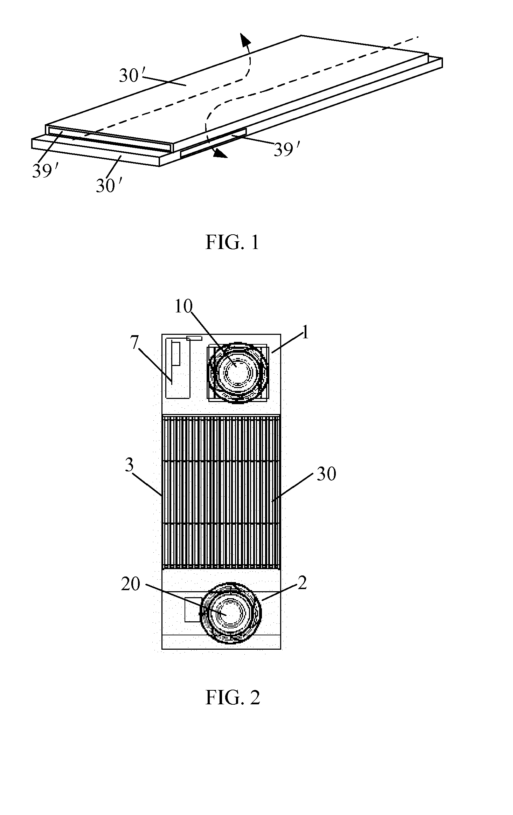

With reference to FIG. 1, this type of recuperative heat exchanger includes a heat exchange core, where heat exchange plates 30' of the heat exchange core are disposed side by side, air ducts 39' are disposed inside the heat exchange plates 30', and hot air and cold air are passing through the air ducts 39' in the adjacent heat exchange plates 30' respectively, in this case, a heat dissipation function is implemented by means of heat and cold exchange.

However, the heat exchange plates in which the air ducts are formed are plain plates. Therefore, when hot air (cold air) enters, air flows in a disorder manner, which may cause air aggregation and cause relatively high air flow resistance, and may further cause that the air cannot smoothly flow out of an outlet, reduce ventilation efficiency, and reduce heat exchange efficiency.

### SUMMARY

Embodiments of the present invention provide a heat exchange plate, heat exchanger, and communication base station cabinet, which can better improve the heat exchange efficiency of a heat exchanger.

To achieve the foregoing objective, the embodiments of the present invention adopt the following technical solutions:

An embodiment of the present invention provides a heat exchange plate, including a heat exchange plate body that has an air duct, where an air inlet is disposed on a first side surface of the heat exchange plate body, an air outlet is disposed on an adjacent second side surface of the heat exchange plate body, the air duct is formed between the air inlet and the air outlet, and a diversion structure for guiding air to flow is disposed inside the air duct.

The diversion structure may be that: in the air duct, a third side surface opposite to the air outlet and a fourth side surface opposite to the air inlet are transitionally connected by using an arc surface;
or in the air duct, a third side surface opposite to the air outlet and a fourth side surface opposite to the air inlet are transitionally connected by using a flat surface;
or in the air duct, a third side surface opposite to the air outlet and a fourth side surface opposite to the air inlet are transitionally connected by using an arc surface and a flat surface.

The diversion structure may be that: a recess part that sinks into the air duct is disposed on the second side surface, where a section of the recess part is formed by an arc surface and a flat surface, the arc surface is tangent to a side surface of the air outlet, and the flat surface is inclined to the second side surface.

The diversion structure may be that: in the air duct, N diversion plates are disposed on a side surface at the air outlet, where the N diversion plates divide the air outlet into N+1 air outlet units.

Optionally, the N diversion plates unevenly divide the air outlet into the N+1 air outlet units.

The diversion plate is formed by a straight plate parallel with an axial direction of the air outlet and an arc plate tangent to the straight plate, and an inner arc surface of the arc plate faces the air inlet;
or the diversion plate is formed by a first straight plate and a second straight plate that form an angle, the first straight plate are parallel with or inclined to an axial direction of the air outlet, and one end of the second straight plate is connected to the first straight plate, and the other end of the second straight plate faces the air inlet.

Further, the N diversion plates divide the air inlet into N+1 air inlet units.

The diversion plate includes a first straight plate parallel with an axial direction of the air inlet and a second straight plate parallel with or inclined to an axial direction of the air outlet, and the first straight plate and second straight plate are transitionally connected by using an arc plate;
or the diversion plate includes a first straight plate parallel with an axial direction of the air inlet and a second straight plate parallel with or inclined to an axial direction of the air outlet, and the first straight plate and the second straight plate are transitionally connected by using a third straight plate.

The diversion structure may also be that: multiple rows of flow around cylinders that have openings and are parallel with an axial direction of the air inlet are disposed on the side surface of one side of the air outlet in the air duct, where each row of flow around cylinder is formed by multiple flow around plates arranged at intervals, and an interval between adjacent flow around plates form the opening.

The flow around plate is formed by a first straight plate, a second straight plate and a third straight plate that are connected sequentially and form angles mutually, and straight plates located on both side surfaces of the opening are parallel.

The diversion structure may also be formed by any two or more of diversion structures in the foregoing content.

In addition, the heat exchange plate is a metal plate or resin plate.

The embodiments of the present invention further provide a heat exchanger, heat exchanger, and communication base station cabinet, including an internal circulation fan system, an external circulation fan system, a heat exchange core, and a monitoring system, where an internal circulation fan unit is disposed in the internal circulation fan system, an external circulation fan unit is disposed in the external circulation fan system, the heat exchange core includes the foregoing heat exchange plate, and air ducts in two adjacent heat exchange plates are an internal circulation air duct and an external circulation air duct.

The internal circulation fan unit and the external circulation fan unit are axial fans or centrifugal fans.

An embodiment of the present invention further provides a communication base station cabinet, including a cabinet, where the heat exchanger described in the foregoing content is disposed in the cabinet.

The embodiments of the present invention provide a heat exchange plate, including a heat exchange plate body that has an air duct, an air inlet is disposed on a first side surface of the heat exchange plate body, an air outlet is disposed on an adjacent second side surface of the heat exchange plate body, and the air duct is formed between the air inlet and air outlet, and because a diversion structure for guiding air to flow is disposed in the air duct, in this case, after air flows into the air duct from the air inlet, the diversion structure may guide the air to flow orderly in the air duct, prevent air aggregation, and reduce air flow resistance, and further enable the air to flow out of the air outlet more smoothly. Therefore, the ventilation efficiency is better improved and the heat exchange efficiency of a heat exchanger is better improved.

### BRIEF DESCRIPTION OF DRAWINGS

To describe the technical solutions in the embodiments of the present invention or in the prior art more clearly, the following briefly introduces the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.
FIG. 1 is a schematic diagram of a heat exchange plate in a heat exchanger in the prior art;
FIG. 2 is a schematic diagram of a heat exchanger according to an embodiment of the present invention;
FIG. 3 is a first schematic diagram of a heat exchange plate according to Embodiment 1 of the present invention;
FIG. 4 is a second schematic diagram of a heat exchange plate according to Embodiment 1 of the present invention;
FIG. 5 is a third schematic diagram of a heat exchange plate according to Embodiment 1 of the present invention;
FIG. 6 is a first schematic diagram of a heat exchange plate according to Embodiment 2 of the present invention;
FIG. 7 is a first schematic diagram of a heat exchange plate according to Embodiment 3 of the present invention;
FIG. 8 is a second schematic diagram of a heat exchange plate according to Embodiment 3 of the present invention;
FIG. 9 is a first schematic diagram of a heat exchange plate according to Embodiment 4 of the present invention;
FIG. 10 is a second schematic diagram of a heat exchange plate according to Embodiment 4 of the present invention;
FIG. 11 is a third schematic diagram of a heat exchange plate according to Embodiment 4 of the present invention;
FIG. 12 is a schematic diagram of a heat exchange plate according to Embodiment 5 of the present invention;
FIG. 13 is a schematic diagram of a diversion structure, which is of a heat exchange plate and is formed by a diversion structure in Embodiment 1 and a heat conduction structure in Embodiment 2, according to the present invention;
FIG. 14 is a schematic diagram of a diversion structure, which is of a heat exchange plate and is formed by the diversion structure in Embodiment 1 and a heat conduction structure in Embodiment 3, according to the present invention;
FIG. 15 is a schematic diagram of a diversion structure, which is of a heat exchange plate and is formed by the diversion structure in Embodiment 1 and a heat conduction structure in Embodiment 4, according to the present invention;
FIG. 16 is another schematic diagram of a diversion structure, which is of a heat exchange plate and is formed by the diversion structure in Embodiment 1 and the heat conduction structure in Embodiment 4, according to the present invention;
FIG. 17 is a schematic diagram of a diversion structure, which is of a heat exchange plate and is formed by the diversion structure in Embodiment 1, the heat conduction structure in Embodiment 3, and the heat conduction structure in Embodiment 4, according to the present invention;
FIG. 18 is another schematic diagram of a diversion structure, which is of a heat exchange plate and is formed by the diversion structure in Embodiment 1, the heat conduction structure in Embodiment 3, and the heat conduction structure in Embodiment 4, according to the present invention;
FIG. 19 is a schematic diagram of a diversion structure, which is of a heat exchange plate and is formed by the diversion structure in Embodiment 1, the heat conduction structure in Embodiment 3, the heat conduction structure in Embodiment 4, and a heat conduction structure in Embodiment 5, according to the present invention; and
FIG. 20 is another schematic diagram of a diversion structure, which is of a heat exchange plate and is formed by the diversion structure in Embodiment 1, the heat conduction structure in Embodiment 3, the heat conduction structure in Embodiment 4, and the heat conduction structure in Embodiment 5, according to the present invention.

### Reference numerals:

1-internal circulation fan system, 10-internal circulation fan unit, 2-external circulation fan system, 20-external circulation fan unit, 3-heat exchange core, 30-heat exchange plate, 31-first side surface, 32-second side surface, 33-third side surface, 34-fourth side surface, 35, 35', 37-arc surfaces, 36, 36'-flat surfaces, 39, 39'-air ducts, 310-air inlet, 320-air outlet, 40-straight plate, 40', 50, 60-first straight plates, 41, 51-arc plate, 42, 52, 52', 61-second straight plates, 53, 62-third straight plates, 63-opening, 7-monitoring system

### DESCRIPTION OF EMBODIMENTS

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

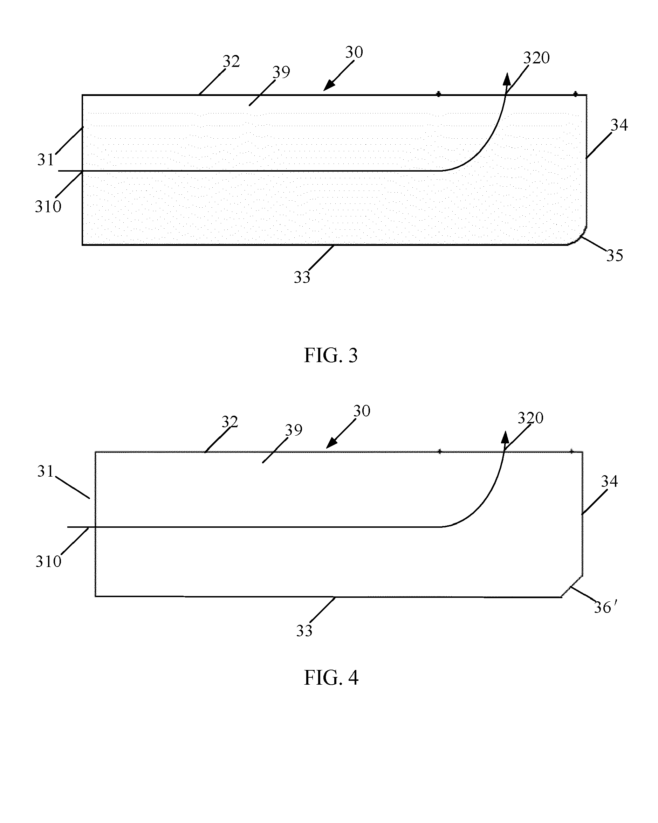

FIG. 3 shows a specific embodiment of a heat exchange plate 30 according to the present invention. The heat exchange plate 30 includes a heat exchange plate body that has an air duct 39, an air inlet 310 is disposed on a first side surface 31 of the heat exchange plate body and an air outlet 320 is disposed on an adjacent second side surface 32 of the heat exchange plate body, the air duct 39 is formed between the air inlet 310 and the air outlet 320, and a diversion structure for guiding air to flow is disposed in the air duct 39.

Because the diversion structure for guiding air to flow is disposed in the air duct 39, in this case, after the air flows into the air duct 39 from the air inlet 310, the diversion structure may guide the air to flow in the air duct 39 orderly and prevent air aggregation, and reduce air flow resistance, and further enable the air to flow out of the air outlet 320 more smoothly. Therefore, the ventilation efficiency is better improved, and the heat exchange efficiency of a heat exchanger is better improved.

### Embodiment 1

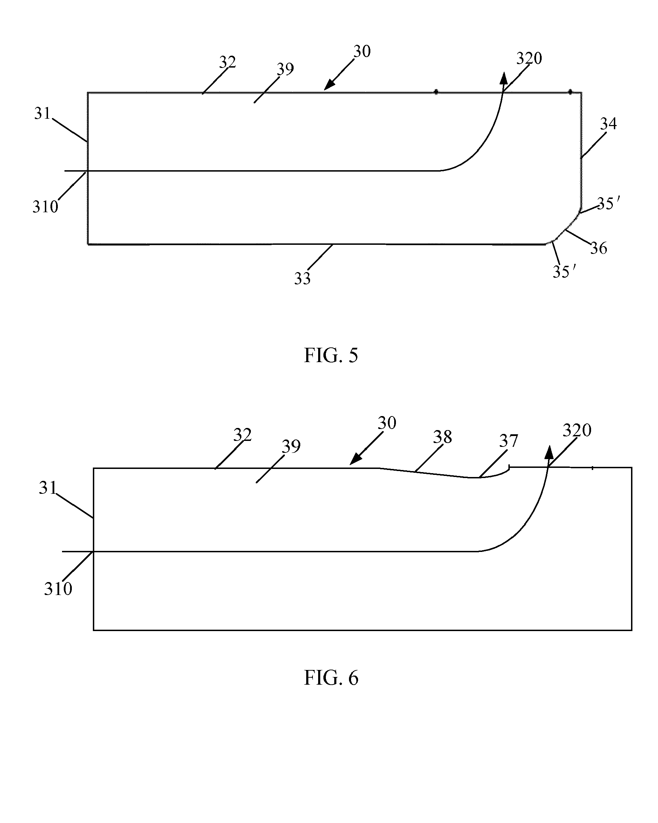

The diversion structure may be that: as shown in FIG. 3, in the air duct 39, a third side surface 33 opposite to the air outlet 320 and a fourth side surface 34 opposite to the air inlet 310 are transitionally connected by using an arc surface 35, where a section line of the arc surface 35 may be 1/4 of an arc, and a radius of the formed arc section line may be from 5 mm to 60 mm;
or, as shown in FIG. 4, in the air duct 39, a third side surface 33 opposite to the air outlet 320 and a fourth side surface 34 opposite to the air inlet 310 are transitionally connected by using a flat surface 36, where angles formed between the flat surface 36 and the third side surface 33 and between the flat surface 36 and the fourth side surface 34 may be 45°, and a length of a section line of a flat surface 36' may be from 5 mm to 60 mm;
or, as shown in FIG. 5, in the air duct 39, a third side surface 33 opposite to the air outlet 320 and a fourth side surface 34 opposite to the air inlet 310 are transitionally connected by using an arc surfaces 35' and the flat surface 36, angles formed between the flat surface 36 and the third side surface 33 and between the flat surface 36 and the fourth side surface 34 may be 45°, where the third side surface 33 and the fourth side surface 34 are adjacent to the flat surface 36. A length of a section line of the flat surface 36 may be from 5 mm to 60 mm; the arc surface 35' is formed between the flat surface 36 and the third side surface 33 or the fourth side surface 34, a section line of the arc surface 35' may be 1/8 of an arc and a radius of the arc section line of the arc surface 35' may be from 5 mm to 30 mm; in addition, there may be one arc surface 35', or there are two arc surface 35' as shown in FIG. 5, which are disposed at both ends of the flat surface 36 respectively.

### Embodiment 2

As shown in FIG. 6, the diversion structure may be that: a recess part that sinks into the air duct 39 is disposed on the second side surface 32, a section of the recess part is formed by an arc surface 37 and a flat surface 38, the arc surface 37 is tangent to a side surface of the air outlet 320, and the flat surface 38 is inclined to the second side surface 32, in this case, when air flows to the air outlet 320, the recess part may change a flow direction of the air, which may reduce interference of the air at the air outlet 320, and may further improve the ventilation efficiency.

A shape of a section line of the arc surface 38 may be 1/8 to 7/8 of an arc and a radius of an arc section line of the arc surface 38 may be from 5 mm to 30 mm; an opening width of the recess part is at least greater than 10 mm.

### Embodiment 3

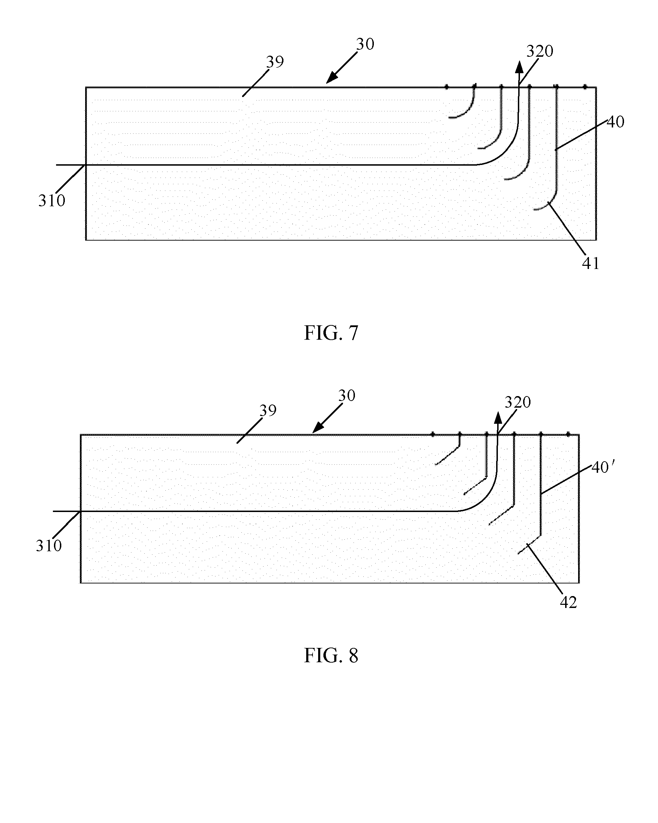

With reference to FIG. 7 or FIG. 8, the diversion structure may also be that: N (N is greater than or equal to 1) diversion plates are disposed on a side surface at the air outlet 320 in the air duct 39, where the N diversion plates divide the air outlet 320 into N+1 air outlet units and division proportions may be equal proportions or different proportions. When air flows near the air outlet 320, the air may flow out of the air outlet more orderly under the effect of multiple air outlet units, and occurrence of a phenomenon that a heat exchange effect is poor due to disorder flow when air outflows is minimized.

Because the diversion plates are sequentially arranged in the air duct 39 in a step manner, lengths (a length direction herein refers to a direction in which air flows from the air inlet to the air outlet) of the diversion plates increase sequentially, and in this case, a flow path of the air in a lowest-layer air duct unit is relatively short while a flow path of the air in a highest-layer air duct unit is relatively long. When the air duct units are formed by division of equal proportions, air may be subject to relatively high flow resistance at the lowest layer and subject to relatively low flow resistance at the highest layer, which cause uneven air flow resistance in each air duct unit and may cause an unsatisfactory ventilation effect. To prevent this phenomenon, widths of low-layer air duct units may be set to be wider and widths of high-layer air duct units may be set to be narrower, which may enable air in each air duct unit to be subject to relatively even flow resistance and ensure more smooth ventilation. Therefore, as an optional solution, the N diversion plates may divide the air outlet 320 into N+1 air duct units unevenly.

As shown in FIG. 7, the diversion plate is formed by a straight plate 40 parallel with an axial direction of the air outlet 320 and an arc plate 41 tangent to the straight plate 40, and an inner arc surface of the arc plate 41 faces the air inlet 310. The arc plate 41 may be, for example, of a shape of 1/8 to 7/8 of an arc, and a radius of an arc section line of the arc plate 41 may be from 5 mm to 30 mm; the sum of a length of an Nth straight plate 40 and a radius of the arc plate 41 is equal to N/(N+1) times of a width of the air duct 39; in addition, the straight plate 40 may be a whole structure, and may also be a segmented structure.

Alternatively, as shown in FIG. 8, the diversion plate is formed by a first straight plate 40' and a second straight plate 42 in which the first straight plate 40' and the second straight plate 42 form an angle, the first straight plate 40' is parallel with or inclined to an axial direction of the air outlet 320, and one end of the second straight plate 42 is connected to the first straight plate 40', and the other end of the second straight plate 42 faces the air inlet 310, where the angle formed by the first straight plate 40' and the second straight plate 42 may be, for example, 135°. Similarly, the sum of a length of an Nth first straight plate 40' and a length of a 45° opposite side of the second straight plate 42 is equal to N(N+1) of a width of the air duct 39; and the straight plate 40' may be a whole structure, and may also be a segmented structure.

### Embodiment 4

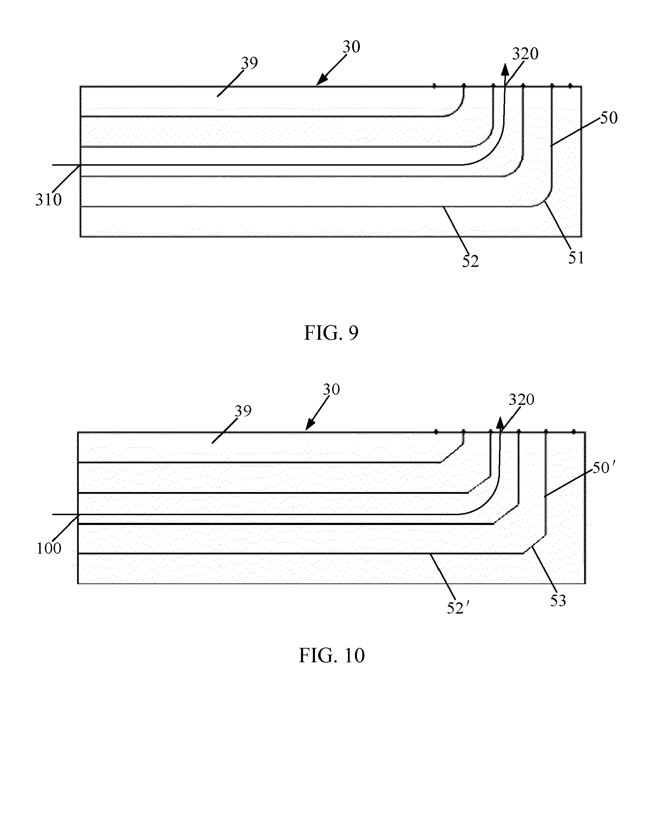

As shown in FIG. 9 to FIG. 11, with reference to Embodiment 3, the N (N is greater than or equal to 1) diversion plates may also divide the air inlet 310 into N+1 air inlet units. Further, the N diversion plates divide the air duct 39 into N+1 air duct units, and in this case, air may flow, by guiding of the air duct units, into the air inlet units and out of the air outlet units to enable the air to flow in the air duct 39 orderly, which relatively facilitates to improve ventilation efficiency, and further improve heat exchange efficiency.

In this embodiment, with reference to FIG. 9, the diversion plate may include a first straight plate 50 parallel with or inclined to an axial direction of the air inlet 310 and a second straight plate 52 parallel with an axial direction of the air outlet 320, the first straight plate 50 and the second straight plate 52 are transitionally connected by using an arc plate 51, the arc plate 51 may be, for example, of a shape of 1/4 of an arc, and a radius of an arc section line of the arc plate 51 may be from 5 mm to 30 mm.

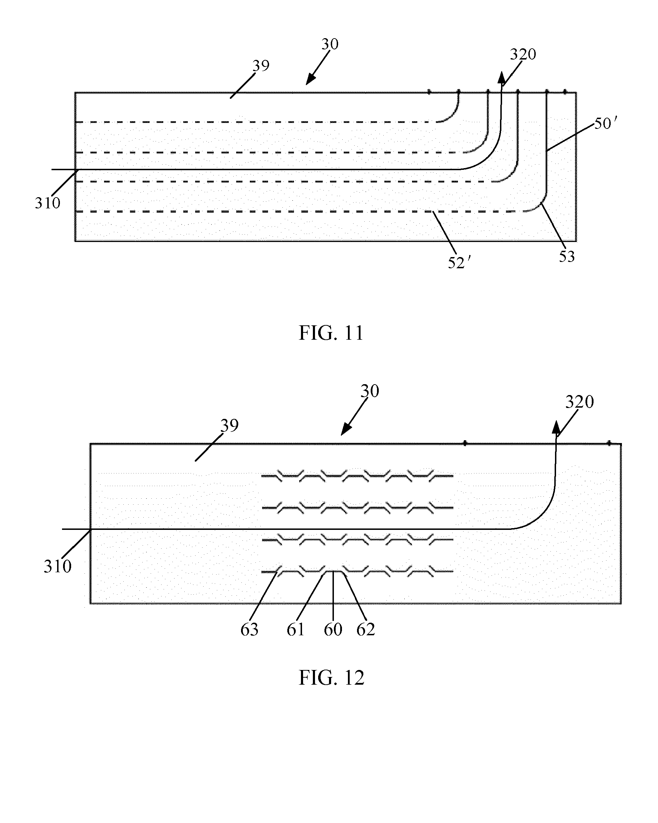

Alternatively, as shown in FIG. 10, the diversion plate includes a first straight plate 50' parallel with or inclined to an axial direction of the air inlet 310 and a second straight plate 52' parallel with an axial direction of the air outlet 320, the first straight plate 50' and the second straight plate 52' are transitionally connected by using a third straight plate 53, that is, the third straight plate 53 forms an angle with each of the first straight plate 50' and the second straight plate 52', and the angle may be 135°; and it may be known from FIG. 11 that, both the first straight plate 50' and the third straight plate 52' may be a whole structure, and may also be a segmented structure.

### Embodiment 5

As shown in FIG. 12, the diversion structure may also be that: multiple rows of flow around cylinders that have openings 63 and are parallel with an axial direction of the air inlet 310 are disposed on a side surface of a side of the air outlet 320 in the air duct, where each row of flow around cylinders is formed by multiple flow around plates arranged at intervals, and an interval between adjacent flow around plates forms the opening 63, in this case, a fluid boundary layer may be destroyed, air may move around in the air duct 39 through the opening 63 to enhance the turbulence heat exchange efficiency, strengthen the ventilation efficiency, and improve the heat exchange efficiency.

As an optional solution, the flow around plate may be formed by a first straight plate 61, a second straight plate 60, and a third straight plate 62 that are connected sequentially and form angles mutually, and straight plates located on both sides of the opening 63 are parallel, where angles between the first straight plate 61 and the second straight plate 60 and between the third straight plate 62 and the second straight plate 60 may be from 10° to 170°, lengths of section lines of the first straight plate 61, the second straight plate 60, and the third straight plate 62 may all be 2 to 20 mm, and a width of the opening 63 may be 2 to 10 mm.

In addition, heights of the diversion plates in Embodiment 3 and Embodiment 4 and the flow around plate mentioned in Embodiment 5 may all be 1/4 to 1 time of a height (it should be noted that, the height herein is along a thickness direction of the heat exchange plate) of the air duct 39.

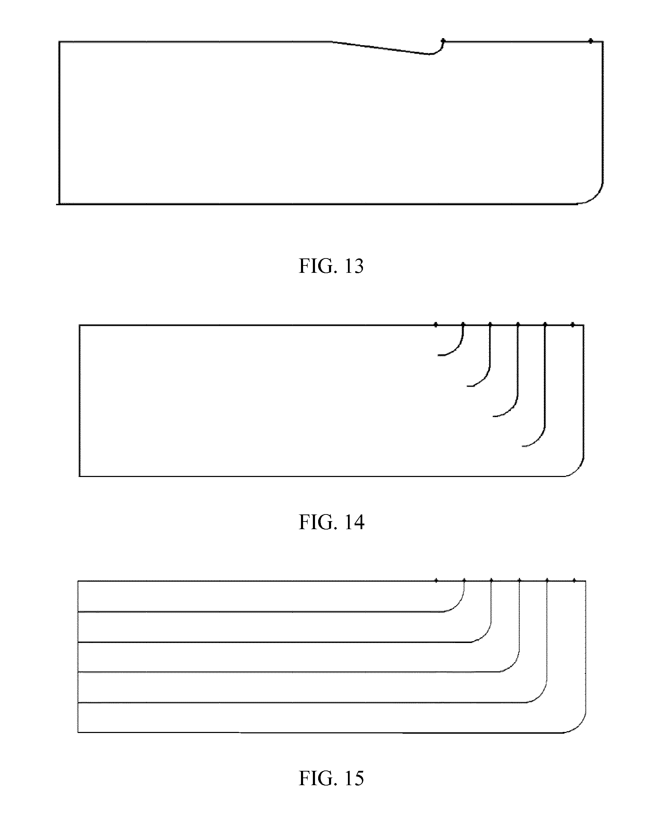

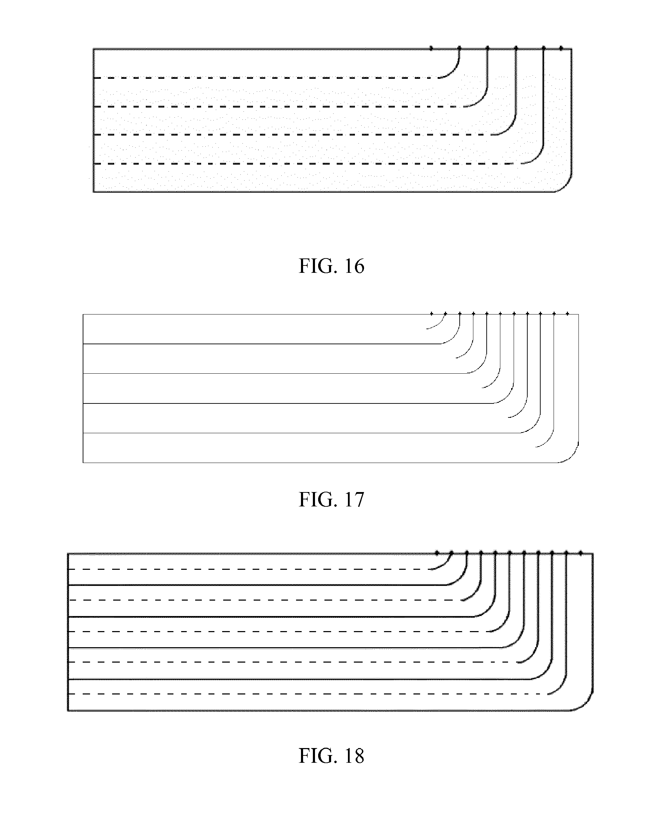

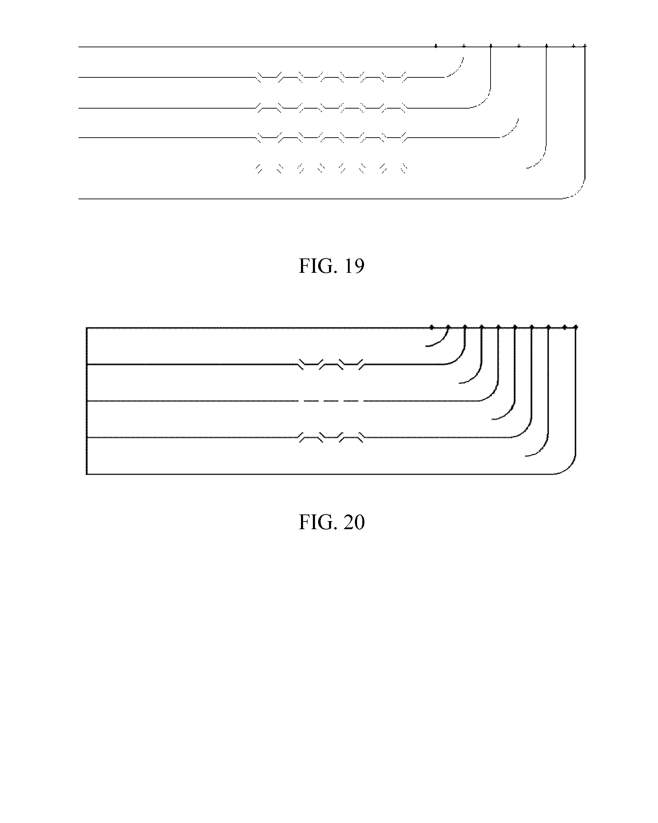

The diversion structure may also be formed by any two or more of the diversion structures in the foregoing content, which may be more conducive to the air flow efficiency and strengthen the heat exchange efficiency. For example, as shown in FIG. 13, a diversion structure may be formed by diversion structures in Embodiment 1 and Embodiment 2; or as shown in FIG. 14, a diversion structure may be formed by diversion structures in Embodiment 1 and Embodiment 3; or still as shown in FIG. 15 and FIG. 16, a diversion structure may be formed by diversion structures in Embodiment 1 and Embodiment 4; or still as shown in FIG. 17 or FIG. 18, a diversion structure may be formed by diversion structures in Embodiment 1, Embodiment 3, and Embodiment 4; or still as shown in FIG. 19 and FIG. 20, a diversion structure may be formed by diversion structures in Embodiment 1, Embodiment 3, Embodiment 4, and Embodiment 5. The foregoing two or more diversion structures are only used as examples for description and are not limited thereto. Because a diversion structure may be formed by any two or more diversion structures in Embodiment 1 to Embodiment 5, therefore detailed listing is not provided herein.

In addition, the heat exchange plate 30 may be a metal plate or may be a resin plate.

Parameter values mentioned in the foregoing embodiments are merely optional solutions in the embodiments of the present invention. Specific parameter values may be determined according to situations.

With reference to FIG. 2, an embodiment of the present invention further provides a heat exchanger, including an internal circulation fan system 1, an external circulation fan system 2, a heat exchange core 3, and a monitoring system 7, where an internal circulation fan unit 10 is disposed in the internal circulation fan system 1, an external circulation fan unit 20 is disposed in the external circulation fan system 2, the heat exchange core 3 includes the heat exchange plate 30 described in the foregoing content, and air ducts in two adjacent heat exchange plates 30 are an internal circulation air duct and an external circulation air duct respectively.

In the heat exchanger provided by the embodiment of the present invention, because a diversion structure for guiding air to flow is disposed in the air duct 39, in this case, after air flows from the air inlet 310 into the air duct 39, the diversion structure may guide the air to flow orderly in the air duct 39 and prevent air aggregation, and may further reduce air flow resistance, and further enable the air to flow out of the air outlet 320 more smoothly. Therefore, the ventilation efficiency is better improved and the heat exchange efficiency of the heat exchanger is better improved.

It should be noted that, because the diversion structure in the heat exchange plate 30 may enable that the heat exchange efficiency of the heat exchanger is improved, in this case, a heat exchanger with a small size may be used to replace a heat exchanger with a large size, so as to reduce costs.

The internal circulation fan unit 10 and the external circulation fan unit 20 may be axial fans or centrifugal fans.

Generally, the heat exchange plates 30 are arranged in the heat exchange core in a relatively dense manner and minimum plate spacing between two adjacent heat exchange plates 30 may reach 2 mm, which also causes large air flow resistance in the air duct 39. Because a pressure head of a centrifugal fan is relatively high, under most conditions, a centrifugal fan may be used to enable the air in the air duct 39 to outflow.

An embodiment of the present invention further provides a communication base station cabinet, including a cabinet, where the heat exchanger described in the foregoing content is disposed in the cabinet. This heat exchanger may be used to enable air inside and outside the cabinet to orderly flow in the air duct 39 of the heat exchange plate 30 to prevent air aggregation, reduce air flow resistance, and further enable the air to flow out of the air outlet 320 more smoothly. Therefore, on a premise that internal and external isolation, reliability, noise, and environmental protection of a cabinet are ensured, the ventilation efficiency may be better improved, and the heat exchange efficiency of the heat exchanger is better improved.

According to the foregoing content and FIG. 2, an operating principle of the heat exchanger in the cabinet in the embodiments of the present invention is that: cool air outside the cabinet is driven by the external circulation fan unit 20 to enter the external circulation air duct from an inlet of the external circulation air duct, and hot air inside the cabinet is driven by the internal circulation fan unit 10 to enter the internal circulation air duct from an inlet of the internal circulation air duct, and at this time, the hot air in the internal circulation air duct transfers heat to the cool air in the external circulation air duct by using the heat exchange plates. In this case, the cooled internal circulating air is driven by the internal circulation fan unit to be fed into the cabinet from an outlet of the internal circulation air duct, which may further reduce temperature for a device in the cabinet, while the heated external circulating air is driven by the external circulation fan unit and discharged from an outlet of the external circulation air duct, so as to bring heat generated by the device in the cabinet to an atmospheric environment.

In the heat exchange plate in the embodiments of the present invention, structures that may enhance heat exchange efficiency, such as a ripple or vortex generator or a windowed flow around plate may be added. In this case, a heat exchange capability of the heat exchange plate may be further enhanced, and the heat exchange efficiency of the heat exchanger may be further enhanced.

The foregoing descriptions are merely specific implementation manners of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A heat exchange plate, comprising a heat exchange plate body that has an air duct, wherein an air inlet is disposed on a first side surface of the heat exchange plate body and an air outlet is disposed on an adjacent second side surface of the heat exchange plate body, the air duct is formed between the air inlet and the air outlet, and a diversion structure for guiding air to flow is disposed inside the air duct.

2. The heat exchange plate according to claim 1, wherein the diversion structure is that: in the air duct, a third side surface opposite to the air outlet and a fourth side surface opposite to the air inlet are transitionally connected by using an arc surface;
or in the air duct, a third side surface opposite to the air outlet and a fourth side surface opposite to the air inlet are transitionally connected by using a flat surface;
or in the air duct, a third side surface opposite to the air outlet and a fourth side surface opposite to the air inlet are transitionally connected by using an arc surface and a flat surface.

3. The heat exchange plate according to claim 1, wherein the diversion structure is that: a recess part that sinks into the air duct is disposed on the second side surface, a section of the recess part is formed by an arc surface and a flat surface, the arc surface is tangent to a side surface of the air outlet, and the flat surface is inclined to the second side surface.

4. The heat exchange plate according to claim 1, wherein the diversion structure is that: N diversion plates are disposed on a side surface of the air outlet in the air duct, and the N diversion plates divide the air outlet into N+1 air outlet units.

5. The heat exchange plate according to claim 4, wherein the N diversion plates unevenly divide the air outlet into N+1 air outlet units.

6. The heat exchange plate according to claim 5, wherein the diversion plate is formed by a straight plate parallel with an axial direction of the air outlet and an arc plate tangent to the straight plate, and an inner arc surface of the arc plate faces the air inlet;
or the diversion plate is formed by a first straight plate and a second straight plate that form an angle, wherein the first straight plate is parallel with or inclined to an axial direction of the air outlet, and one end of the second straight plate is connected to the first straight plate and the other end of the second straight plate faces the air inlet.

7. The heat exchange plate according to claim 5, wherein the N diversion plates divide the air inlet into N+1 air inlet units.

8. The heat exchange plate according to claim 7, wherein the diversion plate comprises a first straight plate parallel with or inclined to an axial direction of the air inlet and a second straight plate parallel with an axial direction of the air outlet, and the first straight plate and the second straight plate are transitionally connected by using an arc plate;
or the diversion plate comprises a first straight plate parallel with an axial direction of the air inlet and a second straight plate parallel with or inclined to an axial direction of the air outlet, and the first straight plate and the second straight plate are transitionally connected by using a third straight plate.

9. The heat exchange plate according to claim 1, wherein the diversion structure is that: multiple rows of flow around cylinders that have openings and are parallel with an axial direction of the air inlet are disposed on a side surface of one side of the air outlet in the air duct, wherein each row of flow around cylinder is formed by multiple flow around plates arranged at intervals, and an interval between adjacent flow around plates form the opening.

10. The heat exchange plate according to claim 9, wherein the flow around plate is formed by a first straight plate, a second straight plate, and a third straight plate that are connected sequentially and form angles, and straight plates located on both side surfaces of the opening are parallel with each other.

11. The heat exchange plate according to claim 1, wherein the diversion structure is formed by any two or more diversion structures according to claims 2 to 9.

12. The heat exchange plate according to any one of claims 1 to 11, wherein the heat exchange plate is a metal plate or plastic plate or resin plate.

13. A heat exchanger, comprising an internal circulation fan system, an external circulation fan system, a heat exchange core, and a monitoring system, wherein an internal circulation fan unit is disposed in the internal circulation fan system; an external circulation fan unit is disposed in the external circulation fan system; the heat exchange core comprises the heat exchange plate according to any one of claims 1 to 11, and air ducts in two adjacent heat exchange plates are an internal circulation air duct and an external circulation air duct.

14. The heat exchange plate according to claim 13, wherein the internal circulation fan unit and the external circulation fan unit are axial fans or centrifugal fans.

15. A communication base station cabinet, comprising a cabinet, wherein the heat exchanger according to claim 13 or 14 is disposed in the cabinet.
